# EUROPEAN PATENT APPLICATION

(11) **EP 1 598 857 A1**
(43) Date of publication of application: **23.11.2005**
(21) Application number: 04711480.6
(22) Date of filing: 16.02.2004
(51) Int. Cl.: H01L 21/285, H01L 21/3205, H01L 27/04, H01J 37/317, B82B 3/00, C23C 16/46

(54) **PRODUCTION METHOD FOR ANTENNA AND PRODUCTION DEVICE FOR ANTENNA**

(30) Priority: 28.02.2003 JP 2003054362
(71) Applicant: Japan Science and Technology Agency, Kawaguchi-shi, Saitama 332-0012 (JP)
(72) Inventor: HOSHINO, Takayuki, Shibuya-ku, Tokyo 151-0063 (JP); MATSUI, Shinji, Himeji-shi, Hyogo 670-0083 (JP); KONDO, Kazushige, Himeji-shi, Hyogo 671-2201 (JP)
(74) Representative: Hoarton, Lloyd Douglas Charles
(86) International application number: PCT/JP2004/001625
(87) International publication number: WO 2004/077536

(57) **Abstract**

It is provided a production method of a free-space-wiring and a production apparatus thereof, enabling to fabricate the free-space-wiring in the nm order.

The free-space-wiring (3) is fabricated using a CVD process by irradiating a beam based on three-dimensional positional data as well as an irradiation position, an irradiation direction and irradiation time of the beam prestored in a computer-controlled drawing device (9) to utilize a beam excitation reaction.

## Description

### TECHNICAL FIELD

The present invention relates to a production method of a free-space-wiring with a diameter in the nm order by growing a conductor from a substrate surface or a three-dimensional (3D) structure utilizing a beam excitation reaction of such as focused-ion-beam (FIB), and a production apparatus of the free-space-wiring.

### BACKGROUND ART

The technology of two-dimensional (2D) nanoprocessing has been developed significantly in accordance with the progress in the research and development of the semiconductor manufacturing process, resulting in 10-nm lithography using EB (Electron Beam) or FIB (Focused Ion Beam) being enabled, which is in turn applied to the fabrication of such as an ultra-thin MOS device with less than a 50-nm gate length or a quantum-effect device of the 10-nm level, e.g., a single-electron transistor (see Non-Patent Documents 1 and 2). In this manner, the 2D nanoprocessing technology has been substantially established at the research and development level. The future research and development of the nanoprocessing technology aims at multi-dimensionalization of the processing from two- to three-dimensional, and the resultant multi-functionality and high performance, while there is a need for the research and development of new functional devices which could not have been realized yet.

It is necessary for fabrication of a structure in the nm order, as in the case of the 2D fabrication, to utilize FIB or EB with high resolution. There has been reported the formation of a structure in a pillar or a wall shape using FIB or the fabrication of a field emitter or a photonic crystal structure using EB (see Non-Patent Documents 3 and 4). However, the foregoing techniques reported ever have not realized the fabrication of an arbitrary 3D structure.

Therefore, the present inventors have developed the technology to realize fabrication of the arbitrary 3D structure with the size of less than 100 nm, which has not been achieved yet, using FIB-CVD (Focused Ion Beam-Chemical Vapor Deposition) (see Patent Document 1 and Non-Patent Document 5).

### [Patent Document 1]

Japanese Unexamined Patent Publication No. 2001-107252 (pages 3-4, Fig. 1)

### [Non-Patent Document 1]

S. Matsui and Y. Ochiai, Nanotechnology, 7, 247(1996)

### [Non-Patent Document 2]

S. Matsui, Proceedings of the IEEE, 85, 629(1997)

### [Non-Patent Document 3]

H. W. Koops, Jpn. J. Appl. Phys., Part 1 33, 7099(1994)

### [Non-Patent Document 4]

P. G. Blauner, Proceedings International Microprocess Conference, 1991, p.309

### [Non-Patent Document 5]

S. Matsui, K. Kaito, J. Fujita, M. Komuro, K. Kanda, and Y. Haruyama, J. Vac. Sci. Technol., B18, 3168(2000)

### DISCLOSURE OF THE INVENTION

Since a 2D drawing technique has its limits as for the electronic device integration, it is required to fabricate a wiring in the nm order within a 3D space.

Moreover, a free-space-wiring in the nm order is necessary for the wiring of a microelectronic device such as a microcoil.

The present invention is intended to provide a production method of a free-space-wiring and a production apparatus thereof, enabling to fabricate the free-space-wiring in the nm order.

To achieve the above objects, the present invention provides the following:
[1] A production method of a free-space-wiring, wherein the free-space-wiring is fabricated using a CVD process, by irradiating a beam based on three-dimensional positional data as well as an irradiation position, an irradiation direction and irradiation time of the beam prestored in a computer-controlled drawing device to utilize a beam excitation reaction.
[2] The production method of the free-space-wiring according to [1], wherein the beam excitation reaction is caused by the focused ion beam using a liquid metal ion source.
[3] The production method of the free-space-wiring according to [1], wherein the free-space-wiring is fabricated arbitrarily in space.
[4] The production method of the free-space-wiring according to [1], wherein a simple source gas is used as a source gas for fabrication.
[5] The production method of the free-space-wiring according to [1], wherein free-space-wiring characteristics are controlled by applying a mixed gas of the source gas with a different source gas.
[6] The production method of the free-space-wiring according to [1], wherein a metal, a semiconductor, or an insulator free-space-wiring is formed by selecting a reaction gas source.
[7] The production method of the free-space-wiring according to [1], wherein an electronic device is connected to the free-space-wiring.
[8] The production method of the free-space-wiring according to [7], wherein the electronic device is a resistor, a capacitor, or an inductor.
[9] The production method of the free-space-wiring according to [8], wherein a reaction gas material adapted to the resistor, the capacitor, or the inductor is selected to achieve a reaction gas supply control corresponding to the resistor, the capacitor, or the inductor respectively.
[10] The production method of the free-space-wiring according to [7], wherein a semiconductor material is locally doped into the free-space-wiring by focused ion beam injection.
[11] The production method of the free-space-wiring according to [8], wherein the semiconductor material is locally doped into the free-space-wiring by electron beam irradiation in doping gas atmosphere.
[12] The production method of the free-space-wiring according to [1], wherein a semiconductor device is brought into the free-space-wiring using a laser or an electrostatic manipulator to be fixed in the free-space-wiring using the CVD method.
[13] The production method of the free-space-wiring according to [12], wherein the CVD method is the Focused-Ion - Beam CVD method or the Electron-Beam CVD method.
[14] The production method of the free-space-wiring according to [1], wherein a three-dimensional information network is constructed in a local space by an electron/ion beam excitation process.
[15] The production method of the free-space-wiring according to [1], wherein a crossbar circuit is formed by the free-space-wiring.
[16] A production apparatus of a free-space-wiring comprising: a three-dimensional nanostructure; a reaction gas to affect a region of the three-dimensional nanostructure and beam excitation reaction means; a computer-controlled drawing device to control a beam from the beam excitation reaction means in accordance with three-dimensional positional data, wherein a pre-designed free-space-wiring is fabricated using a CVD process by utilizing the beam excitation reaction.

### BRIEF DESCRIPTION OF THE DRAWINGS

Fig. 1 is a schematic diagram of a production apparatus of a free-space-wiring by focused ion beam according to a first embodiment of the present invention;
Fig. 2 is a diagram illustrating an example (Example 1) of fabricating a 3D nanowiring using phenanthrene (C₁₄H₁₀) as a simple carbon source;
Fig. 3 is a diagram illustrating an example (Example 2) of fabricating the 3D nanowiring using phenanthrene (C₁₄H₁₀) as the simple carbon source;
Fig. 4 is a diagram obtained through a TEM observation of a branching section of a wiring;
Fig. 5 is a diagram illustrating a layout drawing of an apparatus for evaluating electrical properties of the free-space-wiring and an example of measurement data;
Fig. 6 is a schematic diagram of an elemental analysis of the free-space-wiring and a graph showing an EDX elemental analysis result of free-space-wiring spectra;
Fig. 7 is a table showing results of the elemental analysis and the electrical property evaluation;
Fig. 8 is a schematic diagram of a production apparatus of the free-space-wiring by the focused ion beam according to a second embodiment of the present invention;
Fig. 9 is an SIM image of the free-space-wiring grown into a crossbar structure according to an embodiment of the present invention;
Fig. 10 is an SIM image of a DLC free-space-wiring fabricated in a bridge shape according to an embodiment of the present invention; and
Fig. 11 is an SIM image of a DLC free-space-wiring in parallel coil shapes according to an embodiment of the present invention.

### BEST MODE FOR CARRYING OUT THE INVENTION

Embodiments of the present invention will be described in detail hereinbelow.

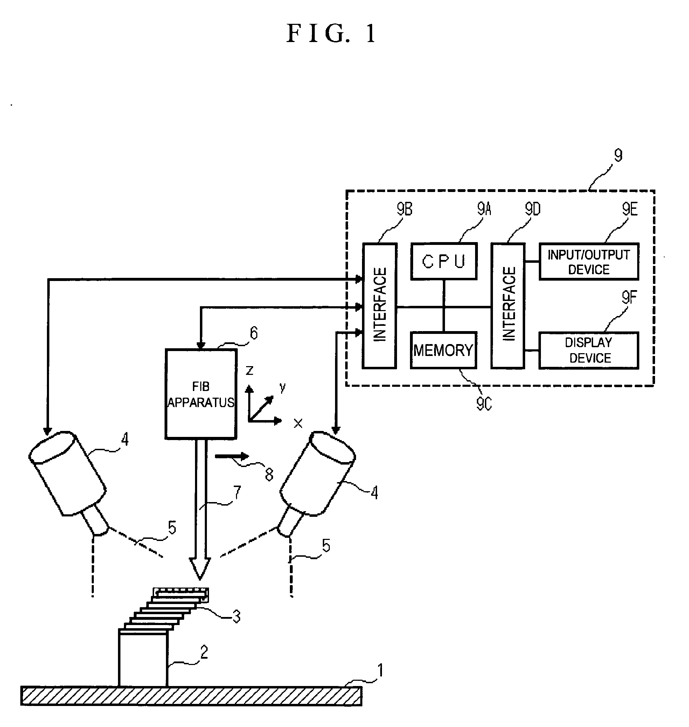

Fig. 1 is a schematic diagram of a production apparatus of a free-space-wiring by focused ion beam according to a first embodiment of the present invention.

In this figure, reference numeral 1 denotes an Si substrate, 2 denotes a DLC (Diamond Like Carbon) pillar as a deposition structure, 3 denotes a free-space-wiring having a width to be hooked up onto the DLC pillar 2, 4 denotes a gas nozzle to inject phenanthrene gas (a melting point: 99 °C, a boiling point: 340 °C) as a reaction gas, 5 denotes phenanthrene gas as the reaction gas, 6 denotes an FIB apparatus, 7 denotes FIB, 8 denotes a scanning direction of FIB 7, and 9 denotes a computer-controlled drawing device, which is provided with a CPU (Central Processing Unit) 9A, interfaces 9B and 9D, a memory 9C prestoring 3D positional data, a beam irradiation position, an irradiation direction and an irradiation time, an input/output device 9E, and a display device 9F.

Here, the free-space-wiring 3 having the width to be hooked up onto the DLC pillar 2 can be grown in the phase of phenanthrene gas 5 as the reaction gas utilizing a beam excitation reaction of the focused ion beam (FIB) 7.

In this illustrative embodiment, the free-space-wiring 3 having a certain width was fabricated in the phase of carbon-based gas (phenanthrene: C¹⁴H¹⁰) by the excitation reaction using a Ga⁺ focused-ion-beam apparatus (Seiko Instruments Inc.: SMI9200). A deposited material was identified to be diamond-like carbon (DLC) by Raman spectroscopy.

The energy of Ga⁺ ions is 30 keV, and the irradiation ion current is at the degree of 1 pA to 1 nA. When Ga⁺ FIB is irradiated onto the Si substrate 1 in the reaction gas 5 atmosphere, reaction gas molecules adsorbed on the irradiation spot are decomposed to grow amorphous carbon. Phenanthrene gas 5 used as the reaction gas is an aromatic hydrocarbon compound having the melting point of 99 °C and the boiling point of 340 °C. It is heated to approximately 70 to 80 °C and resulting vapor is injected to the Si substrate 1 from the tip of the gas nozzle 4. The degree of vacuum of the apparatus is approximately 1 x 10⁻⁵ Pa, an average gas pressure in a sample chamber during the growth of the amorphous carbon is approximately 5 x 10⁻⁵ Pa.

Although Ga⁺ is used here for FIB, it is not limited thereto and any liquid metal ion source, such as Au⁺ or Si⁺, may be used.

Moreover, a fabrication principle of the 3D free-space-wiring by FIB is described.

Chemical vapor deposition by irradiating FIB is processed by the reaction gas molecules absorbed on the substrate or the surface of a growing structure being decomposed and deposited by secondary electrons. Generally, upon irradiation of the ion beam, the secondary electrons are emitted in the interaction process of elastic/inelastic scattering when primary ions penetrate the substrate or the deposition. In case of Ga⁺ ions of 30 keV, the range is approximately 20 nm.

That is, the primary ions are scattered in the range of within approximately 20 nm radius from the irradiation position of the ion beam and the secondary electrons are emitted from the scattering region. The secondary electrons emitted out onto the substrate surface having relatively low energy are trapped immediately by absorption gas molecules because of the large reaction cross section, and the amorphous carbon is grown by the secondary electrons decomposing the reaction gas molecules.

In this process, the amorphous carbon pillar will grow in the beam direction by fixing the irradiation position of the ion beam. By shifting the beam irradiation position slightly in the lateral direction, a generation region of secondary electrons will also shifted simultaneously. That is, the increase in the amount of the secondary electron on the pillar side surface in the shifting direction (right side in Fig. 1) initiates the growth of the branched amorphous carbon in the lateral direction. In this process, the scattering primary ions would not pass the spread amorphous carbon branches because the Ga⁺ ion range is short.

That is, the growth of the branches overhung in the lateral direction is enabled by the secondary electrons being generated efficiently from the tips of amorphous carbon branches and the decomposition/deposition reaction being continued at the tips of branches. Therefore, the control of the growth in the upward or lateral direction, and even in the downward direction can be realized by controlling the scanning speed of the ion beam and the growth rate.

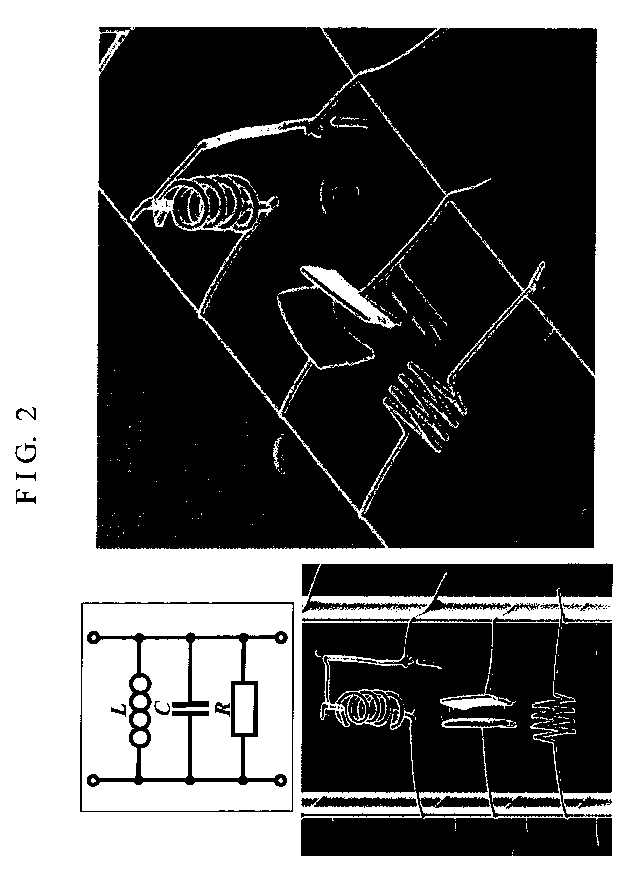

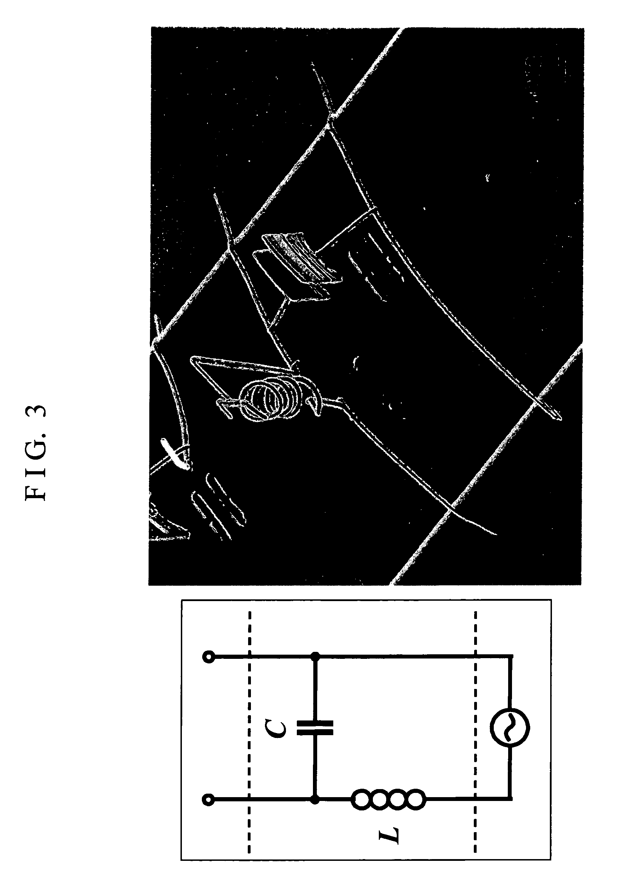

Examples of fabricating 3D nanowiring using the phenanthrene (C₁₄H₁₀) as a simple carbon source are shown in Fig. 2 (L, C, R parallel circuit, growth time: 20 min.) and Fig. 3 (L, C, R filter circuit, growth time: 21 min.). Wiring diameter is approximately 100 nm for both.

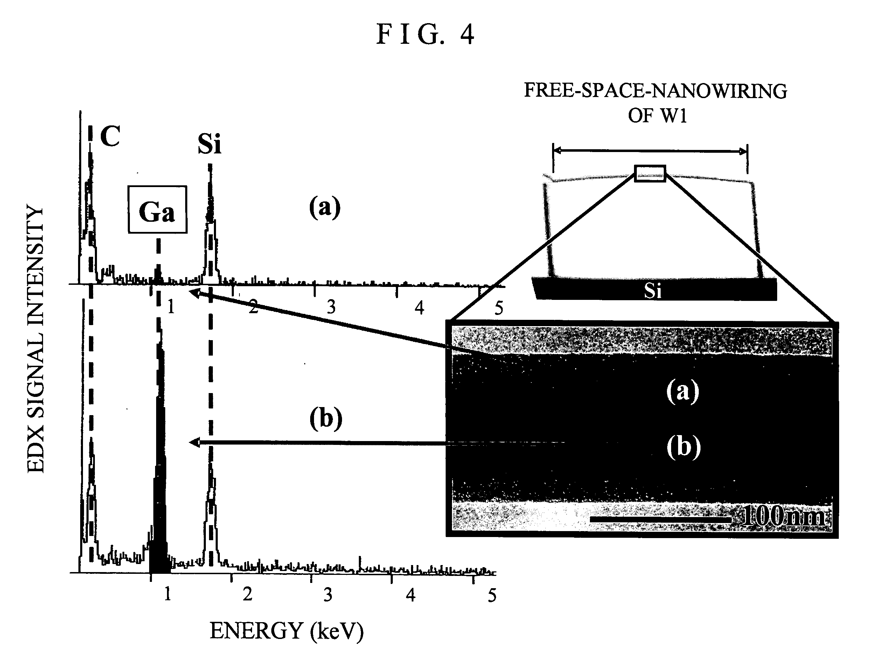

To examine the composition and structure of the fabricated 3D nanowiring, (1) an observation using TEM-EDX was performed. Fig. 4 shows the TEM observation result of a branching section of the wiring performed under 200 keV. From this result, the distributions and positions of Ga and C within the 3D nanowiring were specified. The analyzed area was within the diameter of less than 20 nm.

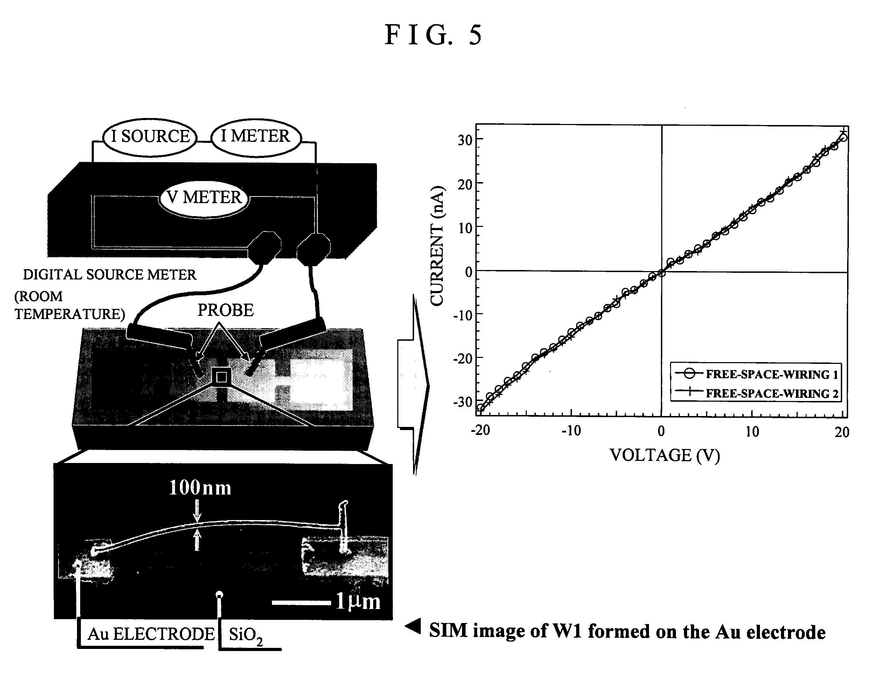

Moreover, (2) the experiment to examine the electrical properties of the fabricated 3D nanowiring was performed. Fig. 5 shows a diagram illustrating a layout drawing of an apparatus for evaluating electric properties of the free-space-wiring and an example of measurement data. In this experiment, a mixed gas containing tungsten carbonyl (W(CO)₆) gas (organometallic gas) supplied simultaneously with phenanthrene gas is used as the source gas to decrease the wiring resistivity. The measurement result of the resistivity shows that, while the resistivity of wiring fabricated using phenanthrene gas only was 100 Ωcm, the resistivity of wiring fabricated by simultaneously supplying tungsten carbonyl gas as well can be decreased to 0.02 Ωcm. That is, the wiring with the variable resistivity capable of being reduced to 1/10000 can be fabricated by supplying tungsten carbonyl gas.

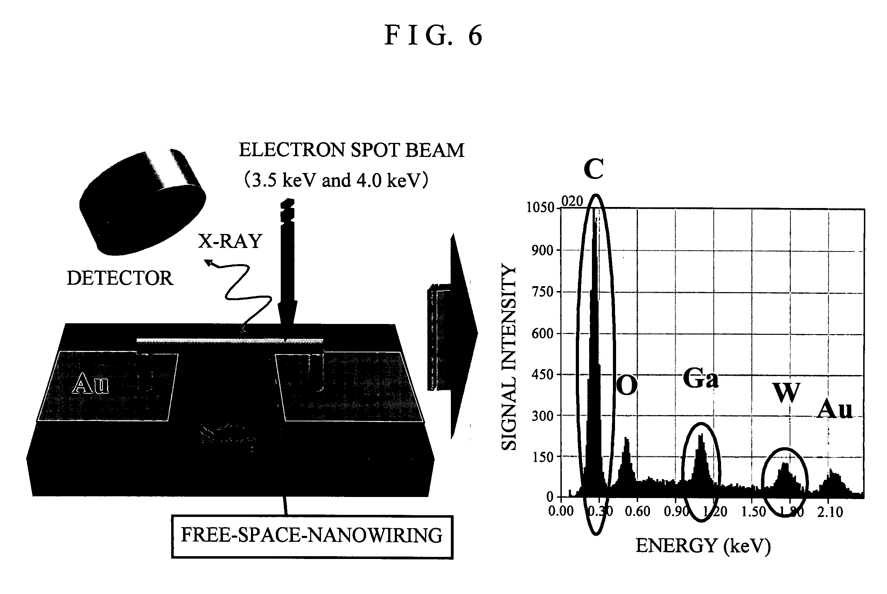

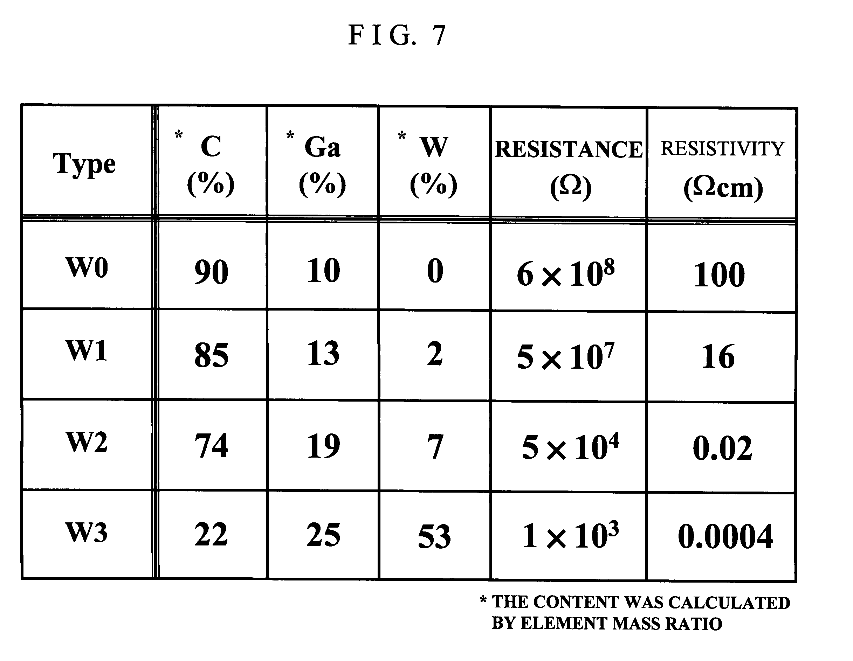

Furthermore, for the purpose of elucidating the relationship between the change in the resistivity and the structural change within the wiring, (3) the experiment was performed to examine the element content inside the wiring using the SEM-EDX electron spot beam, as shown in Fig. 6. The measurement result shows that, as the density of tungsten carbonyl gas increases, the content of metal elements, i.e., Ga and W, increases and the resistivity of the 3D nanowiring decreases. Fig. 7 shows the relationship between the resistivity measured by SEM-EDX and the content of W.

Simple source gas can be used for fabrication as the source gas.

The characteristics of the free-space-wiring can be controlled by applying the mixed gas of the source gas with a different source gas.

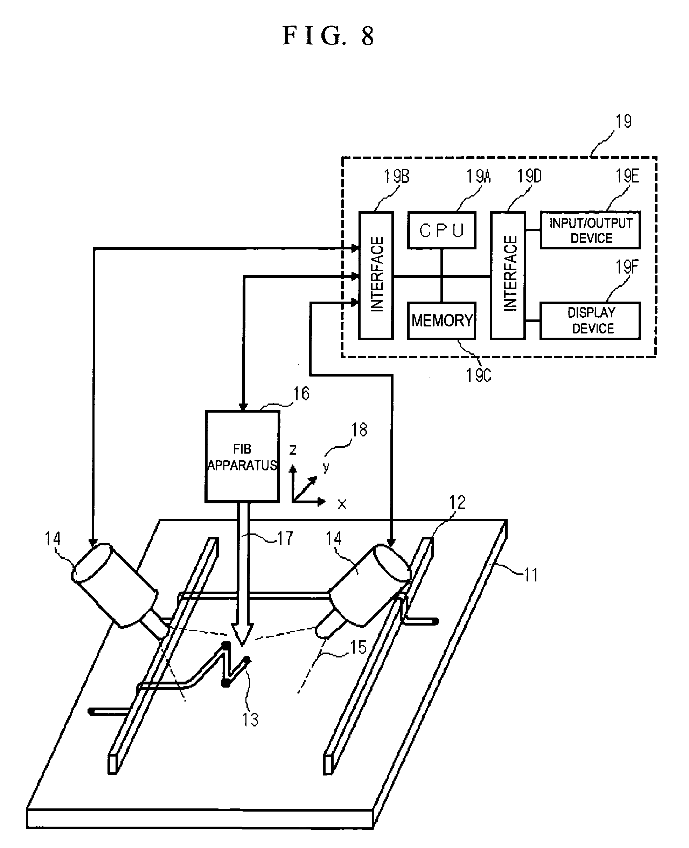

Fig. 8 is a schematic diagram of a production apparatus of the free-space-wiring by the focused ion beam according to a second embodiment of the present invention.

In this figure, reference numeral 11 denotes a substrate, 12 denotes an insulating plate, 13 denotes a free-space-wiring under fabrication, 14 denotes a gas nozzle to inject phenanthrene gas (a melting point: 99 °C, a boiling point: 340 °C) as the reaction gas, 15 denotes phenanthrene gas as the reaction gas, 16 denotes an FIB apparatus, 17 denotes FIB, 18 denotes a scanning direction of FIB 17, and 19 denotes a computer-controlled drawing device, which is provided with a CPU (Central Processing Unit) 19A, interfaces 19B and 19D, a memory 19C prestoring 3D positional data, a beam irradiation position, an irradiation direction and an irradiation time, an input/output device 19E, and a display device 19F.

As shown in Fig. 8, the free-space-wiring 13 is fabricated based on the 3D positional data as well as the beam irradiation position, direction and time prestored in the memory 19C of the computer-controlled drawing device 19.

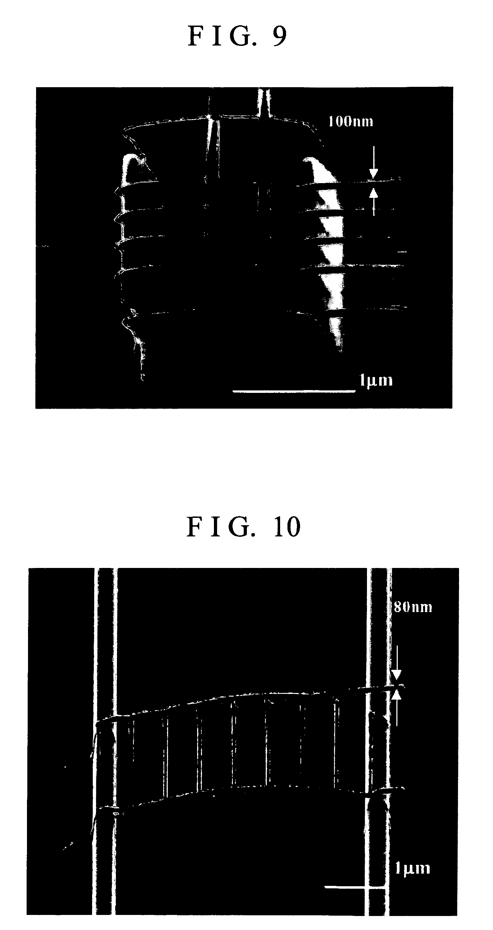

Fig. 9 is an SIM (Scanning Ion Microscope) image (ion microscopic image) of the free-space-wiring grown into a crossbar structure according to the embodiment of the present invention.

The wiring is fabricated into the crossbar structure having the wiring diameter of 100 nm by the DLC wiring, under the fabrication conditions of; the beam current of 0.5 pA, the dose shift of 2.7 ms/nm, and the exposure time of 147s. A metal wiring crossbar logical circuit can be formed by applying the organometallic gas as the reaction gas source.

Moreover, the free-space-wiring is formed with the wiring diameter of 100 nm and the fabrication time of 90 sec. using Ga⁺ FIB of 30 keV, such that a resistance, a capacitor, an inductor or the like can be arbitrarily formed within the free-space-wiring. In the actual wiring, the gas source capable of depositing the metal such as Au, Pt, or W is used.

Furthermore, in this embodiment, the heterojunction formation can be achieved by supplying the different reaction gas source during the growth.

That is, during fabrication of the free-space-wiring, local doping such as PN junction is performed by changing the reaction gas source into such as P and N dopants, a 3D information network including both electronic and optical devices can be constructed.

The fabrication conditions in this embodiment are; the beam current of 0.5 pA and the dose shift of 2.7 ms/nm.

Fig. 10 is an SIM image of the DLC free-space-wiring fabricated in a bridge shape according to the embodiment of the present invention, wherein the fabrication conditions thereof are; the beam current of 0.3 pA, the dose shif of 3.0 ms/nm, and the exposure time of 107 sec.

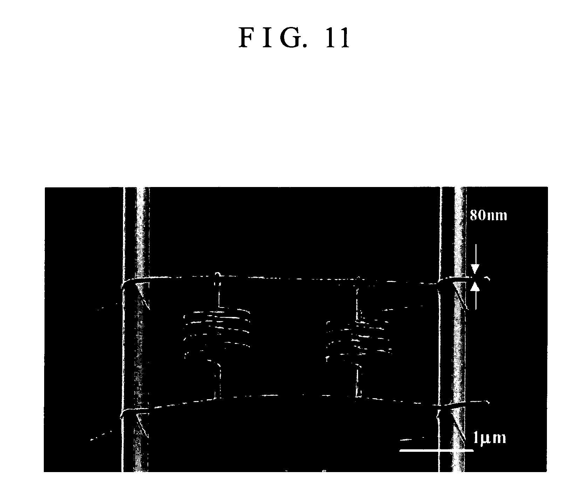

Fig. 11 is an SIM image of the DLC free-space-wiring in parallel coil shapes according to the embodiment of the present invention, wherein the fabrication conditions thereof are; the beam current of 0.3 pA, the dose shift of 3.0 ms/nm, and the exposure time of 166 sec.

As described above, according to the present invention:
(1) Since the beam diameter of the focused ion beam can be focused to approximately 5 nm, the free-space-wiring in the level of several tens of nanometers can be obtained using the 3D data of the computer-controlled pattern drawing device.
(2) The 3D wiring can be formed by various materials, i.e., metal, semiconductor, or insulator materials, by changing the reaction gas. Obviously, the 3D compound free-space-wiring including portions formed by different materials within a single 3D structure can be formed.

Using these characteristics, a nanospace 3D information network or a biomanipulator incorporating such as L, C, R, PN junctions in the free-space-wiring thereof can also be fabricated.

In the production method of the free-space-wiring according to the present invention, a semiconductor material can be locally doped into the free-space-wiring by focused ion beam injection.

Moreover, in the production method of the free-space-wiring according to the present invention, the semiconductor material can be locally doped into the free-space-wiring by electron beam irradiation in the doping gas atmosphere.

Furthermore, in the production method of the free-space-wiring according to the present invention, a semiconductor device can be brought into the free-space-wiring using a laser or an electrostatic manipulator, and can be fixed therein using the CVD method.

Additionally, in the production method of the free-space-wiring according to the present invention, the CVD method can be the FIB-CVD method or the EB-CVD method.

While the present invention is not limited to the foregoing embodiments, various modifications can be made according to the purpose of the present invention and are not excluded from the scope of the present invention.

As described above in detail, the following effects can be achieved according to the present invention.
(A) The free-space-wiring in the order of *µ*m to nm can be fabricated into arbitrary shape and size, allowing a 3D functional device being fabricated.
(B) The 3D wiring can be formed by various materials, i.e., metal, semiconductor, or insulator materials, by changing the reaction gas. Additionally, the 3D compound free-space-wiring including portions formed by different materials within a single 3D structure can be formed.

### INDUSTRIAL APPLICABILITY

The production method of the free-space-wiring and the production apparatus of the free-space-wiring according to the present invention are applicable to, for example, a microswitch, a sensor, a manipulator such as the biomanipulator, a microwave antenna, or a quantum device.

## Claims

1. A production method of a free-space-wiring, wherein the free-space-wiring is fabricated using a CVD process, by irradiating a beam based on three-dimensional positional data as well as an irradiation position, an irradiation direction and irradiation time of the beam prestored in a computer-controlled drawing device to utilize a beam excitation reaction.

2. The production method of the free-space-wiring according to Claim 1, wherein the beam excitation reaction is caused by the focused ion beam using a liquid metal ion source.

3. The production method of the free-space-wiring according to Claim 1, wherein the free-space-wiring is fabricated arbitrarily in space.

4. The production method of the free-space-wiring according to Claim 1, wherein a simple source gas is used as a source gas for fabrication.

5. The production method of the free-space-wiring according to Claim 1, wherein free-space-wiring characteristics are controlled by applying a mixed gas of the source gas with a different source gas.

6. The production method of the free-space-wiring according to Claim 1, wherein a metal, a semiconductor, or an insulator free-space-wiring is formed by selecting a reaction gas source.

7. The production method of the free-space-wiring according to Claim 1, wherein an electronic device is connected to the free-space-wiring.

8. The production method of the free-space-wiring according to Claim 7, wherein the electronic device is a resistor, a capacitor, or an inductor.

9. The production method of the free-space-wiring according to Claim 8, wherein a reaction gas material adapted to the resistor, the capacitor, or the inductor is selected to achieve a reaction gas supply control corresponding to the resistor, the capacitor, or the inductor respectively.

10. The production method of the free-space-wiring according to Claim 7, wherein a semiconductor material is locally doped into the free-space-wiring by focused ion beam injection.

11. The production method of the free-space-wiring according to Claim 8, wherein the semiconductor material is locally doped into the free-space-wiring by electron beam irradiation in doping gas atmosphere.

12. The production method of the free-space-wiring according to Claim 1, wherein a semiconductor device is brought into the free-space-wiring using a laser or an electrostatic manipulator to be fixed in the free-space-wiring using the CVD method.

13. The production method of the free-space-wiring according to Claim 12, wherein the CVD method is the Focused-Ion -Beam CVD method or the Electron-Beam CVD method.

14. The production method of the free-space-wiring according to Claim 1, wherein a three-dimensional information network is constructed in a local space by an electron/ion beam excitation process.

15. The production method of the free-space-wiring according to Claim 1, wherein a crossbar circuit is formed by the free-space-wiring.

16. A production apparatus of a free-space-wiring comprising:
(a) a three-dimensional nanostructure;
(b) a reaction gas to affect a region of the three-dimensional nanostructure and beam excitation reaction means;
(c) a computer-controlled drawing device to control a beam from the beam excitation reaction means in accordance with three-dimensional positional data, wherein:
(d) a pre-designed free-space-wiring is fabricated using a CVD process by utilizing the beam excitation reaction.
